# EUROPEAN PATENT SPECIFICATION

(11) **EP 1 779 512 B1**
(45) Date of publication and mention of the grant of the patent: **03.04.2013**
(21) Application number: 05773156.4
(22) Date of filing: 11.08.2005
(51) Int. Cl.: H03K 17/16

(54) **METHOD FOR OPERATING AN ELECTRONIC VALVE**
VERFAHREN ZUM BESTÄTIGEN EINES ELEKTRONISCHEN VENTILS
METHODE D'ACTIONNEMENT D'UNE SOUPAPE ELECTRONIQUE

(30) Priority: 12.08.2004 GB 0417930
(43) Date of publication of application: 02.05.2007
(73) Proprietor: Bombardier Transportation GmbH, 10785 Berlin (DE)
(72) Inventor: BELWON, Waldemar, A., S-72241 Västerås (SE)
(74) Representative: Brunotte, Joachim Wilhelm Eberhard
(86) International application number: PCT/EP2005/008860
(87) International publication number: WO 2006/015884

(56) References cited:
- CA-A1- 2 456 681
- US-A- 5 107 190
- US-A- 6 097 582
- STEVE MAPPUS: 'Predictive Control Maximizes Synchronous Rectifier Efficiency', [Online] 01 May 2003, pages 1 - 5 POWER ELECTRONICS TECHNOLOGY Retrieved from the Internet: <URL:http://www.printthis.clickability.com/ pt/cpt?action=cpt&title=Predictive+Control+ Maximizes+Synchronous+Rectifier+Efficiency+ Page+of&expire=&urlID=16361621&fb=Y&url=htt p%3A%2F%2Fpowerelectronics.com%2Fmag%2Fpowe r_predictive_control_maximizes%2Findex.html &partnerID=97651> [retrieved on 2009-10-05]
- ANONYMOUS: 'Issue Index May 2003' POWER ELECTRONICS TECHNOLOGY, [Online] Power Electronics Technology Magazine Retrieved from the Internet: <URL:http://powerelectronics.com/images/Iss ueIndex.pdf> [retrieved on 2012-02-23]

## Description

The invention relates to a method of operating an electronic valve, in particular a valve adapted for use in a high power converter such as an Insulated Gate Bipolar Transistor (IGBT), wherein a process of changing a charging state of a control electrode of the valve is repeatedly performed in a similar manner. More particularly, the invention relates to converters comprising such valves, e.g. for delivering electric energy to a driving motor of a railroad traction vehicle. Furthermore, the invention relates to a corresponding arrangement for operating the electronic valve.

Controlling the valves by using pulse signals generated by a control device is well known in the art. In particular, a first edge of a pulse signal initiates a process of switching-on of at least one of the valves and a second edge of the pulse signal initiates a process of switching-off of the valve or of the valves. The first edge may be defined by a step-like increase of a voltage from a low potential to a high potential at a control signal input of a driver circuit, or, in the case of a light pulse, by a transition from dark to light at a control signal input. The second edge may be defined by a step-like decrease of the voltage from a high potential to a low potential at the control signal input or by a transition from light to dark at the control signal input. In particular, the initiation of the switching process causes a current flow to or from the control electrode (e.g. gate) of the valve, whereby the control electrode is charged or discharged and, as a result, a current flow through the valve is enabled or disabled. However, the invention, which will be described later, can also be applied in connection with other embodiments of initiation and/or control of the switching process.

In recent times, collector-emitter voltages of IGBTs have been increased significantly. For example, it has become possible to switch voltages of some thousand volts, for example voltages ranging between 3300 or 6500 volts. As a result, the task of reducing switching losses has gained in significance, particularly where IGBTs are concerned, which are used in converters. The switching speed is an important factor which is to be taken into account for several quantities, such as the individual properties of the IGBT, the operation temperature, the level of the voltage to be switched, the level of the current flowing through the valve and any inaccuracies of a driving device for driving an electric current to or from the control electrode. If a valve, connected in series to another valve is switched too fast, a short circuit may occur. If the switching speed cannot be controlled precisely, it is therefore necessary to slow down the switching process.

CA 2456681 A1 discloses a control process for piloting the opening and/or closure of an electronic power component, wherein the piloting process comprising a plurality of steps for controlling the application of a succession of different commutation voltages on a control electrode of said component between the instant when the piloting process begins and the instant when the opening and/or closure of the electronic power component must stop, the passage from one step to the following step in this piloting process being effected automatically as soon as a corresponding condition of passage is satisfied The control process comprises the following steps: (a) reading the value of at least one operational parameter characteristic of the reaction of the electronic power component in response to the successive application of said commutation voltages, (b) verifying, thanks to the values read, whether this reaction of the electronic power component is produced in a predetermined imparted time, (c) if so, allowing said piloting process to continue normally, and (d) if not, interrupting said piloting process and immediately triggering of a process for safeguarding the integrity of the electronic power component.

US 5,107,190) discloses a means and a method for power amplifiers to reduce the transient energy dissipated therein. An electronic apparatus is provided for driving a load, comprising a power amplifier having an output for coupling to the load, driver means coupled to the input of the amplifier for providing current thereto during a first portion of a repetitive signal (e.g., when the amplifier is on) sampling means coupled to the output of the amplifier for measuring the amplifier output during a second portion of the repetitive signal following the first portion thereof (e.g., when the amplifier is being turned-off), and feedback means coupled to the sampling means for regulating the current provided to the amplifier during the first portion of a subsequent occurrence of the repetitive signal in response to the sampled output.

According to an embodiment of a power amplifier arrangement, the output of the amplifier is sampled near or during a switching interval during or at the end of a charge storage interval when the amplifier is turning-off. A signal proportional to the sampled output is fed back to adjust the amount of energy, current or charge being supplied to the amplifier when the amplifier is conducting or becoming conductive.

The article "Predictive Control Maximizes Synchronous Rectifier Efficiency" by Steve Mappus, published in Power Electronics Technology, May 2003 discloses a digital control-driven technique that optimizes turn-on and turn-off delays of different MOSFETs in synchronous rectifiers. It uses a closed-loop feedback system to detect body-diode conduction and continuously adjusts dead-time delays to minimize the conduction time interval. The dead time between the turn-off of a main switch and turn-on of the synchronous rectifier is adapted. The dead time is the time between the turn-off of the main switch MOSFET and the turn-on of the other MOSFET.

There are different approaches of performing the control process for switching the valve on or off. All these approaches can be realised in connection with the invention, which will be described later. For example, a voltage source with a controllable voltage can be used in combination with a resistor, located in an electrical connection between the voltage source and the control electrode of the valve. According to another approach, a voltage amplifier with pre-programmed voltage slopes may be used. Furthermore, a current source amplifier with pre-programmed levels of the current to or from the control electrode may be provided. In any case, the process of switching the valve on or switching it off may be divided into a plurality of time zones, wherein the voltage of the voltage source, the voltage slope of the voltage amplifier or the current level of the current source amplifier differ from time zone to time zone. The respective time zone is terminated by an event, such as the event when the gate-emitter voltage of an IGBT reaches a predefined level.

It is an object of the present invention to provide a method and an arrangement of the kind indicated above, whereby it is possible to control the repeated execution of the switching process of the valve with precision in order to allow fast execution of the switching process at small losses.

The present invention is defined by the attached claims.

It is proposed to define a specific operating state of the valve, which operating state can be reached by changing a charging state of a control electrode of the valve, and to monitor whether the specific operating state is reached at a predetermined point in time. For example, the predetermined point in time may be predetermined by a time interval of a set length. The starting point of such a time interval may be defined by receipt of a control signal at a control unit for controlling the process of changing the charging state of the control electrode, wherein the process is initiated on receipt of the control signal or a time period of predetermined length after the receipt.

It is proposed to define a specific operating state of the valve, which operating state can be reached by changing a charging state of a control electrode of the valve, and to monitor whether the specific operating state is reached at a predetermined point in time. For example, the predetermined point in time may be predetermined by a time interval of a set length. The starting point of such a time interval may be defined by receipt of a control signal at a control unit for controlling the process of changing the charging state of the control electrode, wherein the process is initiated on receipt of the control signal or a time period of predetermined length after the receipt.

Alternatively, the time interval may start at a time when the valve reaches a second specific operating state. For example, the second specific operating state may be defined by a first specific (low) collector - emitter voltage and the first specific operating state (which is reached after the second specific operating state) may be defined by a second specific collector - emitter voltage which is higher than the first specific collector - emitter voltage. Other definitions of the first or second specific operating state are possible. For example, the second specific operating state (or a corresponding event) may be defined by reaching a negative threshold for the emitter(Main) - emitter(Kelvin) voltage, indicating the beginning of current reduction.

Preferably, the length of the time interval may be fixed for all similar processes of changing the charging state of the valve, wherein each of the similar processes is to be performed in one of a plurality of consecutive procedures of switching on or switching off the valve.

Furthermore, the following is proposed: A method of operating an electronic valve, in particular a valve adapted for use in a high power converter, wherein
- a process of changing a charging state of a control electrode, in particular of an insulated gate of the valve, is repeatedly performed,
- for an execution of the process, it is determined whether a specific operating state is reached at a predetermined point in time and a corresponding determination result is obtained and
- the process of changing the charging state is adapted for a future execution of the process using the determination result.

An arrangement for operating an electronic valve may comprise:
- a driver device adapted to drive an electric current to and/or from a control electrode of the valve,
- a determining device adapted to determine whether a specific operating state of the valve is reached at a predetermined point in time, and adapted to obtain a corresponding determination result and
- a control unit for repeatedly controlling a process of changing a charging state of the control electrode of the valve in order to switch on or to switch off the valve, wherein the control unit is connected to the determining device or wherein it comprises the determining device, and wherein the control unit is adapted to perform a future execution of the process of changing the charging state of the control electrode by controlling the driver device in a corresponding manner, taking the determination result into account.

The electronic valve may be any valve whose switching process can be controlled by directly or indirectly adjusting the current to or from the control electrode. Examples are: IGBTs and Metall Oxide Field-Effect Transistors (MOSFETs), or more generally speaking, valves that have an insulated control electrode (gate). However, IGBTs are preferred for high-power applications, such as converters used to provide electric energy to power consumers like driving motors or industrial machines.

The specific operating state is to be understood as a state in which at least one quantity, in particular an electric quantity (such as the collector emitter voltage, the gate emitter voltage, the collector current or a derivative) fulfils a defined condition, e.g. a state in which the quantity is equal to a defined value.

Strategies for optimising the switching process have been discussed in detail in many publications before the invention. With the invention, it is now possible to optimise the switching procedure in a simple, but highly effective way. The switching speed of the valve can be precisely controlled by monitoring whether the specific operating state is reached at the predetermined point in time or not.

With the invention, the repeated processes of charging and/or discharging can be controlled in a particularly stable manner, as the determination of whether the specific operating state is reached at the predetermined point in time, and/or the adaptation of the process of changing the charging state can be performed by digital data processing (which is realised in the most preferred embodiment of the invention). Compared to analogue data processing, there is much less sensitivity to noise or interference.

Furthermore, the process of changing the charging state is corrected taking the determination result into account. For example, the current to or from the control electrode (e.g. the gate current) is increased if the specific operating state (which depends on the level or height of the current) is reached too late.

With the invention, a particularly robust auto-correction of the process can be performed: this process is not directly dependent on the determination result, as this would be the case when a deviation between the actual operating state and the (desired) specific operating state (e.g. a voltage deviation) is fed back in a conventional control loop in order to regulate the process in dependence on the extent of the deviation. In particular if a corresponding analogue signal is used (which is typical for conventional control purposes), the process becomes dependent on the operating state and the physical properties of any device which is used to determine and/or feed back the analogue signal. As a result, the process itself becomes dependent on device properties and varying conditions. Furthermore, the control process is sensible to noise and interference. In contrast to this, it is possible to adjust the process in a manner which will be described in more detail and which uses the determination result merely as a "yes-or-no" result: Either the specific operating state is reached or not. However, modifications of this approach are within the scope of the invention as well. Consequently, the process can be controlled more closely to the allowable limits and, as a benefit, switching losses can be reduced. In other words: The valve can safely be operated within the range of allowable limits (e.g. peak voltage, time derivative of voltage, time derivative of current carried by the valve) although the switching losses are low. Furthermore, a safe operation prevents the valve (and, for example, a converter which includes the valve) from being destroyed.

According to a preferred embodiment, the process (and thus the time zone, if applicable) is terminated at or before the predetermined point in time. As a result, it is possible to evaluate the determination result and to adapt the process for future execution, e.g. for the subsequent execution. In all cases, the timing of the process and the predetermined point in time are preferably in a fixed relation, so that the determination result comprises reliable information of how to adapt the process. In the most preferred embodiment, the process has a fixed length, and there is a fixed time difference (which may be zero) between the end time of the process and the predetermined point in time.

Since the adaptation of the process is based on the predetermined point in time, the process can be performed nearly independently from operating conditions. This applies particularly to the operating conditions which influence the switching speed (as mentioned above), as long as the predetermined point in time can precisely be determined. In particular, the clock can be used as well as a clock signal generator for a logic device, which is adapted to control an operation of the valve and, optionally, to control further operational tasks, such as the operation of further valves of a converter and/or the operation of the complete converter, or at least subsystems of the converter. For example, modem logic devices, such as CPLDs (Complex Programmable Logic Devices) and/or FPGAs (Field Programmable Gate Arrays) may be used as the logic device. These logic devices require a clock signal generator, which is operated at a high accuracy, e.g. at an accuracy of at least 100 ppm (=0.01 %). Such a high accuracy is usually sufficient for the determination of the predetermined point in time.

Furthermore, it is not necessary to use a real time clock for the determination of the predetermined point in time. Rather, it is possible, for example, to count clock signals of the clock signal generator triggered by a trigger signal. E.g. the trigger signal may be signal which initiates the switching-on or switching-off of the valve.

Preferably, the process is one of a plurality of consecutive processes to be performed in order to change the charging state of the control electrode, in particular in order to switch the valve on or to switch it off. For example, it is possible to define a specific operating state for more than one of the processes, and to subsequently perform the method of the invention for these processes. Thus, these processes can be adapted separately. For example, the current to or from the control electrode can be adjusted separately for these different processes (time zones). Furthermore, the determination result may be obtained for each of a multiplicity of consecutive procedures of switching on and/or switching off the valve.

In particular when the determination result is obtained by digital data processing, it is preferred to define a tolerance time interval, wherein the predetermined point in time is within the tolerance time interval. In this case, it is determined that the specific operating state is reached at the predetermined point in time, if the specific operating state is reached within the tolerance time interval. In other words: it is decided that there is no need to adapt the process of changing the charging state if the specific operating state is reached within the limits of the tolerance time interval.

By way of example, the adaptation of the process of changing the charging state is described in more detail in the following. Preferably, at least one quantity (in particular an electric current to or from the control electrode or a voltage slope of a voltage source is used to drive the electric current) can be adjusted in order to adapt the process, wherein the at least one quantity is adjusted correspondingly to the determination result.

In order to start the operation of the valve (in particular when it is switched on for the first time after a non-working period) with a defined value of the at least one quantity and in order to avoid interference, an initial value of the at least one quantity is chosen so that
- a changing rate of an electric voltage at the valve, or at a driver circuit for controlling an operation of the valve, in particular a gate-emitter voltage,
- this electric voltage and/or
- a changing rate of an electric current flowing through the valve
is/are within specified limits, in particular not greater than a limit. Preferably, the initial value may be chosen so that the limits are not exceeded for the least favourable working conditions of the valve (e.g. the lowest possible operation temperature, the highest possible level of the voltage to be switched, the lowest possible level of the current flowing through the valve).

In particular, an adjustment of the quantity is performed if the specific operating state is not reached within the tolerance time interval for at least one execution of the process.

It is preferred to adjust the at least one quantity by a small amount, in particular by an amount so small that a single adjustment cannot have a negative effect on the operation of the valve during the following switching process, even if the adjustment is performed by mistake (e.g. due to interference or noise). In particular, the amount is so small that the valve can safely be operated within a range of allowable limits (e.g. peak voltage, time derivative of voltage, time derivative of current carried by the valve) during the following switching operation of the valve. The idea behind this embodiment is to make the adaptation of the process particularly stable. One small adjustment cannot result in an operation state which is significantly different from the operation state before the adjustment.

Small adjustments may lead to a slowed adaptation of the process. It might be necessary to perform a plurality of adjustments (e.g. between consecutive switching processes) by a small amount in order to reach the specific operation state in time. However, since a valve is typically switched on and off at switching frequencies of some 100 Hz or some kHz for many applications, and since the operating conditions, such as temperature and voltage to be switched (e.g. collector-emitter voltage) do not change quickly, a slow adaptation is sufficient and does not lead to high overall switching losses. Rather, due to the stable and precise adaptation, it is possible to operate the valve close to the optimal operating situation, i.e. the situation with the smallest switching losses.

In particular, the at least one quantity may be adjusted by a predetermined amount or by a predetermined fraction of the instantaneous value of the quantity (e.g. a fraction which is in the range of 0.1 to 1 % of the instantaneous value and/or a fraction which in the range of 0.1 to 1 % of the maximum value of the at least one quantity), if the specific operating state is not reached at the predetermined point in time. For example, the quantity may be a charging or discharging current which is kept constant during a part of the charging or discharging process. If (by way of example) the maximum charging current is 12 A, adjustment steps of 50 mA may preferably be used in order to adjust the current and in order to reach the specific operating state at the predetermined point in time.

In addition or alternatively, the at least one quantity may be changed to a value selected from a pre-determined set of values, wherein the value is selected according to the determination result.

In all cases which are described in the two preceding paragraphs, the adaptation of the process shows a "digital" behaviour, since the set of possible new values is restricted to a limited number of values.

Furthermore, according to the most preferred embodiment of the invention, the new value of the at least one quantity, which is used to perform the next following process of changing the charging state of the control electrode, is directly dependent on two factors only: the previous value of the quantity and the determination result. Thus, the new value is not influenced by any analogue feedback of the operating state of the valve. In particular, for each process of changing the charging state the control signal applied to the control electrode is "predetermined", except for influences of the environment of the valve which can be considered as constant.

Generally, it is not absolutely necessary to use a tolerance time interval when small adjustment steps are performed. However, according to an embodiment of the invention, the at least one quantity may be adjusted by an amount so small that, after its adjustment, the specific operating state is not reached beyond the tolerance time interval at the next following execution of the process. In other words: the specific operating state will not be reached after the tolerance time interval at the following execution if it was reached before the tolerance time interval at the present execution, and vice versa.

Furthermore, it is preferred that the decision of whether to adapt the process of changing the charging state does not depend on a single determination result only. Rather, the determination result may be obtained for a plurality of executions (e.g. five) of the process, and all these determination results are taken into account. For example, a group with a fixed number of consecutive executions of the process is evaluated for the decision after each execution. More particularly, the decision to adjust the process may only be derived if each of the determination results, which have been taken into account, suggests the adjustment (e.g. the specific operating state has been reached too late for all corresponding executions of the process).

In particular, the process is terminated at the predetermined point in time by changing a value of the at least one quantity, for example by changing the current to or from the control electrode.

There are different options to determine whether the specific operating state is reached at the predetermined point in time. For example, a quantity which is characteristic for an operating state of the valve may be evaluated at the predetermined point in time, and may be compared to a comparison value in order to determine whether the specific operating state is reached at the predetermined point in time.

However, it is preferred to define an event which may occur during or after the process of changing the charging state. At the very time of the event occurring, the specific operating state is reached. Therefore, it is proposed to determine a second point in time where the event occurs, and to evaluate whether the second point in time is before or after the predetermined point in time. The adaptation of the process does not require a value determination of the time difference between the second point in time and the predetermined point in time (it is, nevertheless, possible to use this information for the adaptation). In particular, if the adaptation is performed by adjusting a quantity by a predetermined amount or fraction (as described above), the only requirement will be to know whether the second point in time comes/came before or after the predetermined point in time. As a result, the process can be adapted so that the defined event will occur at the desired (predetermined) point in time, when the process will be executed again

A corresponding embodiment of the arrangement proposed above comprises an event determining device which is connected to the control unit, wherein the event determining device is adapted to determine an occurrence of a predefined event during charging or discharging the control electrode.

Furthermore, the present invention includes a converter for converting a current, in particular for a high power application such as providing electric energy to a driving motor of a railroad traction vehicle. The converter comprises the arrangement proposed above, wherein the converter can be operated by repeatedly switching the valve on and off, and wherein the arrangement and the control electrode are connected to each other via a connection for discharging and/or charging the control electrode.

In addition, the present invention includes the programmable logic device, comprising the control unit of the arrangement proposed above, wherein the programmable logic device is adapted to control the process of changing the charging state of the control electrode, according to one of the embodiments of the method proposed above.

Preferred embodiments of the invention will be described in more detail, with reference to the accompanying schematic drawing by way of example. However, the following description is not intended to limit the scope of protection of the invention. In the drawing, the same reference numerals are used for identical parts or units and for parts or units with a similar function. The figures of the drawing show:
- Fig. 1: an arrangement according to the most preferred embodiment of the invention;
- Fig. 2: an arrangement with a converter and a load;
- Fig. 3: a gate current as a function of time during a process of switching on an IGBT; and
- Fig. 4: a gate current as a function of time during a process of switching off an IGBT

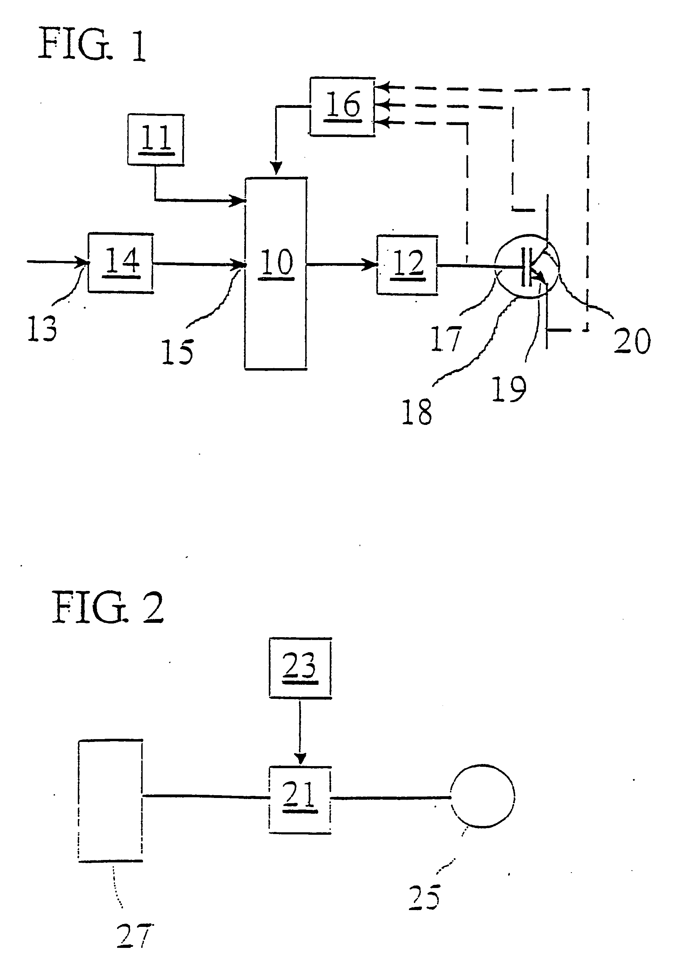

Fig. 1 shows an IGBT 18. The insulated gate of the IGBT 18 is denoted with the reference numeral 17, the collector with the reference numeral 20 and the emitter with the reference numeral 19. An event detecting device 16 for detecting the occurrence of predetermined events is connected to the emitter 19, to the collector 20 and to the gate 17. Considering the IGBT in more detail, the IGBT comprises an emitter (Main) and an emitter (Kelvin). Thus, it is also possible to determine the specific operating state by observing a voltage between the emitter (Main) and the emitter (Kelvin).

A control unit 10 for controlling processes of switching on and switching off the IGBT 18 (and optionally at least one further IGBT) is provided. The event detecting device 16, a gate current amplifier 12 for driving a current to and/or from the gate 17 and a signal converter 14 for converting an optical control signal to an electrical control signal are connected to the control unit 10. The gate current amplifier 12 is connected to the gate 17. Furthermore, a high-precision electronic clock signal generator 11 is connected to the control unit 10.

The control unit 10 may be a programmable logic device. The IGBT 18 - and further electronic valves - may be part of a converter such as the converter 21 shown in Fig. 2, wherein the converter 21 is connected to an energy supply circuit (e. g. a direct current intermediate circuit) or to an energy supply network 27 (e.g. a single-phase alternating current network of a railway system). Furthermore, the converter 21 is connected to a load 25 (e.g. a driving motor of a railroad traction vehicle) and its operation is controlled by a controlling device 23, which controls the operation using PWM signals, for example. In particular, optical switching signals that correspond to the PWM signals may be transferred from the controlling device 23 to the signal converter 14 in order to trigger a switching process to be performed by the control unit 10.

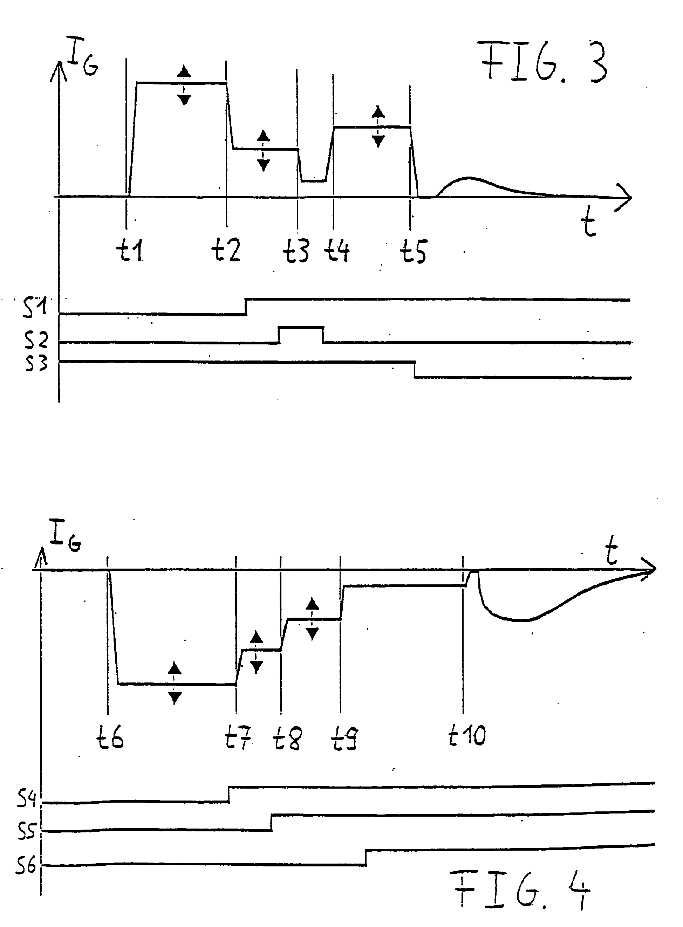

The operation of the arrangement shown in Fig. 1 will be described in the following with reference to Fig. 3 and Fig. 4. When a corresponding optical control signal is received at a signal input 13 of the signal converter 14, the optical signal is converted to an electrical signal, for example by stepping-up a voltage from a low level to a high level. The electrical signal is transferred to a signal input 15 of the control unit 10. On receipt of the control signal (e.g. when the voltage steps-up to the high level) the control unit 10 initiates a procedure of switching on the IGBT 18.

The procedure is divided into a plurality of time zones (first zone: from time t1 to time t2, second zone: from time t2 to time t3, third zone: from time t3 to time t4, fourth zone: from time t4 to time t5), wherein the control unit 10 causes the gate current amplifier 12 to drive a gate current I_{G} of a given, constant height in each of the time zones. The height or level of the gate current I_{G} in at least some of the time zones is dependent on a correction procedure described in the following, wherein the correction procedure corresponds to a preferred embodiment of the invention.

On the other hand, the lengths of the time zones do not depend on the correction procedure. Rather, the lengths are fixed for a given operation state of the arrangement shown in Fig. 2. For example, the lengths may be adapted, if the load 25 is operated in a different manner. In the particular example of Fig. 3, the length of the first time zone is 1 *µs* plus/minus 20 ns, the length of the second time zone is 0.5 *µs* plus/minus 20 ns, the length of the third time zone is 0.3 *µs* plus/minus 20 ns and the length of the fourth time zone is 1 µs plus/minus 20 ns.

In an alternative embodiment, the length of at least one of the time zones can be adjusted, for example in order to adapt the operation to modified operating conditions and/or in order to increase the safety and/or the accuracy of the switching process thus decreasing switching losses.

In order to perform the correction procedure and in order to decide whether the level of the gate current I_{G} is to be adjusted, the time of a predefined event occurring is monitored and/or registered. For example, a corresponding signal is transferred from the event detecting device 16 to the control unit 10 when the event occurs. The control unit 10 determines whether the event occurred before, at or after a predetermined or defined point in time. If the event did not occur at the point in time (or, optionally, within a tolerance period of defined length, including the point in time), the control unit 10 either adjusts the level of the gate current I_{G} for future use in the same time zone of the next following process of switching the valve, or it uses the information obtained to decide later whether such a correction is to be performed.

For example, the correction may be performed if the event repeatedly occurs too early for the corresponding time zones of consecutive switching processes. For example, the correction may be performed only, if the event occurs too late in a predefined number (e. g. five) of consecutive switching processes. This may eliminate the influence of noise and/or any interference.

Clock signals, which are repeatedly transferred from the high precision clock 11 to the control unit 10, are used by the control unit 10 in order to precisely determine the defined point in time. For example, the control signal which initiates the process of switching the valve 18, triggers the start of a counting procedure for counting clock signals, wherein the predetermined point in time corresponds to a specific number of counted signals. When the number of clock signals counted is equal to the specific number, the defined point in time has arrived and the control unit 10 evaluates whether the defined event occurred before or after the end of the time zone (optionally plus or minus a tolerance time). If the event has not occurred yet (optionally including the tolerance time period), it is decided that the event is too late (not in time).

If the control unit 10 decides that the process of charging or de-charging the gate 17 is to be adapted in at least one of the time zones, it outputs a corresponding control signal to the gate current amplifier 12, wherein the control signal causes the gate current amplifier 12 to drive a gate current at the corresponding amended level during the respective time zone.

Furthermore, it is preferred to correct the height of the gate current I_{G} by small steps only, e.g. by steps of smaller or equal to 1 % of a default value of the current. The default value may be used as an initial value at the beginning of an operation of the valve, when the correction process has not been performed yet. After each correction step, it is checked whether the current is still too high (or too low) before a further correction step is performed.

The description of the correction procedure applies to all time zones of the switching process for which an event is defined. In the first time zone of a process of switching on the IGBT 18, the gate 17 is pre-charged. The corresponding defined event is the event that the voltage V_{GE} between the gate 17 and the emitter 19 reaches a defined voltage level, e.g. a voltage level of 3 Volt. In the second zone the actual start of a current flow (collector-emitter current) through the IGBT 18 is prepared. The defined event is the event that an increase of the collector-emitter current occurs for the first time after the first time zone (or an increase is detected). For the third time zone no event is defined. In the third time zone a reverse recovery of a freewheeling diode (not shown in Fig. 1) may be performed. The diode is connected in parallel to a second IGBT, wherein the second IGBT and the IGBT 18 may be connected in series to each other. E.g., the second IGBT and the IGBT 18 may be part of the converter 21 and may be used to control one phase of a three-phase alternating current. In the fourth time zone the voltage V_{CE} between the collector 20 and the emitter 19 is reduced. The defined event is the event that the voltage V_{CE} reaches a defined voltage level.

Fig. 3 shows three time-dependent signals S1, S2, S3, which are transferred from the event detecting device 16 to the control unit 10 and which indicate the occurrence of a corresponding event.

The step-like increase of the signal S1 indicates the occurrence of the event defined for the first time zone. As shown in Fig. 3, the event occurs after time t2 which suggests increasing the level (the plateau) of the gate current. The decision whether the level is actually increased or not may depend on the signal S1 obtained for further executions of the charging process of the first time zone. A corresponding routine which is capable of making the decision is implemented in the control unit 10.

The step-like increase of the signal S2 indicates the occurrence of the event, defined for the second time zone. As shown in Fig. 3, the event occurs earlier than the time t3. This does not necessarily suggest the adjustment (in this case: the decrease) of the level of the gate current during the second time zone, since the event defined for the first time zone did not occur in time. There are different ways of handling this situation. According to a first approach, the occurrence time of the event is compared with time t3, the end time of the second time zone. According to a second approach, the occurrence time of the event is compared with the occurrence time of the event defined for the first time zone (when signal S1 steps-up to a higher signal level), plus the duration of the second time zone.

It is preferred to choose the start values for the gate currents in all time zones in such a manner that all events occur too late at the beginning of the valve operation.

The step-like decrease of the signal S3 indicates the occurrence of the event defined for the fourth time zone. As shown in Fig. 3, the event occurs slightly after the time t5.

Fig. 4 shows a corresponding procedure of switching off the IGBT 18. As in the case of Fig. 3, there are four time zones with constant gate current level, wherein an event is defined and the level of the gate current IG can be adjusted (as indicated by short vertical lines pointing up and down) in a corresponding correction procedure for three of the time zones. Three time-dependent signals S4, S5 and S6, which are transferred from the event detecting device 16 to the control unit 10, indicate the occurrences of the corresponding events.

## Claims

1. A method of operating an electronic valve (18), in particular a valve adapted for use in a power converter, wherein
- a process of changing a charging state of a control electrode (17), in particular of an insulated gate, of the valve (18) is repeatedly performed, wherein the process is a process to be performed for either switching-on or switching-off the valve,
- for an execution of the process, it is determined whether a specific operating state is reached at a predetermined point in time and a corresponding determination result is obtained, wherein the specific operating state is a state in which at least one electric quantity fulfils a pre-defined condition and **characterized in that** the process of changing the charging state is adapted for a future execution of the process using the determination result.

2. The method of the preceding claim, wherein
- depending on the determination result, at least one quantity is adjusted in order to adapt the process of changing the charging state, and
- if the operating state is not reached at the predetermined point in time, the at least one quantity is adjusted by a predetermined amount or by a predetermined fraction of the instantaneous value of the quantity and/or by a predetermined fraction of a maximum value of the quantity.

3. The method of one of the preceding claims, wherein
- depending on the determination result, at least one quantity is adjusted in order to adapt the process of changing the charging state,
- if the operating state is not reached at the predetermined point in time, the at least one quantity is changed to a value selected from a pre-determined set of values, and
- the value is selected according to the determination result.

4. The method of one of the preceding claims, wherein a new value of the at least one quantity is calculated, which new value is valid for the next following execution of the process of changing the charging state of the control electrode, and wherein the new value is unambiguously determined by a previous value of the quantity and by the determination result.

5. The method of any one of the three preceding claims, wherein the at least one quantity is an electric current to or from the control electrode (17).

6. The method of one of the preceding claims, wherein the process of changing the charging state is to be performed within a plurality of time zones of set lengths.

7. The method of one of the preceding claims, wherein the valve (18) comprises a collector, an emitter (Main) and an emitter (Kelvin) and wherein the specific operating state is determined by observing a voltage between the collector and one of the emitters as well as observing a voltage between the emitter (Main) and the emitter (Kelvin).

8. The method of one of the preceding claims, wherein the process of changing the charging state is adapted using the determination result so that the duration of changing the charging state is kept within a time window of predetermined length.

9. The method of one of the preceding claims, wherein the predetermined point in time is predetermined by a time interval of set length.

10. The method of claim 9, wherein the process is initiated on receipt of a control signal at a control unit (10) for controlling the process of changing the charging state of the control electrode (17) and wherein the time interval starts at the time of receipt of the control signal at the control unit (10).

11. The method of claim 9, wherein the specific operating state is a first specific operating state and wherein the time Interval starts at a time when the valve reaches a second specific operating state.

12. The method of one of the preceding claims, wherein the predetermined point in time is defined using a clock (11) and wherein the clock (11) is used as well as a clock signal generator for a logic device, which is adapted to control an operation of the valve.

13. The method of one of the preceding claims, wherein the process is one of a plurality of consecutive processes to be performed in order to change the charging state of the control electrode (17), in particular in order to switch on or in order to switch off the valve (18).

14. The method of one of the preceding claims, wherein a tolerance time interval is defined, wherein the predetermined point in time is within the tolerance time interval and wherein it is determined that the specific operating state is reached at the predetermined point in time, if the specific operating state is reached within the tolerance time interval.

15. The method of one of the preceding claims, wherein at least one quantity, in particular an electric current to or from the control electrode (17), can be adjusted in order to adapt the process and wherein the at least one quantity is adjusted correspondingly to the determination result.

16. The method of claim 15, wherein an initial value of the at least one quantity is chosen, which fulfils one or all of the following conditions:
- a changing rate of an electric voltage at the valve (18), or at a driver circuit (12) for controlling an operation of the valve (18), in particular a gate-emitter voltage,
- the electric voltage,
- a changing rate of an electric current flowing through the valve (18) is/are within specified limits, in particular not greater than a limit.

17. The method of claim 15 or 16, wherein, if the specific operating state is not reached at the predetermined point in time, the at least one quantity is adjusted by a predetermined amount or by a predetermined fraction of the instantaneous value of the quantity.

18. The method of claim 17, wherein the at least one quantity is adjusted by a fraction which is in the range of 0.1 to 1 % of a maximum value of the at least one quantity, if the specific operating state is not reached at the predetermined point in time.

19. The method of one of claims 15 to 18, wherein the process is terminated at the predetermined point in time by changing a value of the at least one quantity, in particular by changing the current to or from the control electrode (17).

20. The method of one of the preceding claims, wherein an event is defined, wherein a second point in time, when the event occurs and thereby the specific operating state is reached, is determined and wherein it is evaluated whether the second point in time is earlier or later than the predetermined point in time.

21. The method of claim 20, wherein the evaluation whether the second point in time is earlier or later than the predetermined point in time is used for the adaptation of the process, if necessary, for the future execution of the process.

22. The method of one the preceding claims, wherein a quantity, which is characteristic for an operating state of the valve (18), is evaluated at the predetermined point in time and is compared to a comparison value in order to determine whether the specific operating state is reached at the predetermined point in time.

23. An arrangement for operating an electronic valve (18), in particular a valve adapted for use in a power converter, wherein the arrangement comprises:
- a driver device (12) adapted to drive an electric current to and/or from a control electrode (17), in particular of an insulated gate, of the valve (18),
**characterized by**
- a determining device (16) adapted to determine for an execution of a process of changing a charging state of the control electrode (17) whether a specific operating state of the valve (18) is reached at a predetermined point in time and adapted to obtain a corresponding determination result, wherein the process is a process to be performed for either switching-on or switching-off the valve, and wherein the specific operating state is a state in which at least one electric quantity fulfils a pre-defined condition, and
- a control unit (10) for repeatedly controlling the process of changing the charging state, wherein the control unit (10) is connected to the determining device or comprises the determining device (16) and wherein the control unit (10) is adapted to perform a future execution of the process of changing the charging state of the control electrode (17) by controlling the driver device (12) in a corresponding manner taking the determination result into account.

24. The arrangement of claim 23, wherein the control unit (10) is connected to a high precision clock (11) which is capable of transferring clock signals to the control unit (10) at an accuracy of at least 100 ppm, preferably of at least 70 ppm.

25. The arrangement of claim 23 or 24, wherein an event determining device (16) is connected to the control unit (10) and wherein the event determining device (16) is adapted to determine an occurrence of a predefined event during charging or discharging the control electrode (17).

26. A converter (21) for converting a current, in particular for a high power application such as providing electric energy to a driving motor (25) of a railroad traction vehicle, wherein the converter (21) comprises the arrangement of one of claims 23 to 25, wherein the converter (21) can be operated by repeatedly switching-on and off the valve (18) and wherein the arrangement and the control electrode (17) are connected to each other via a connection for discharging and or charging the control electrode.

27. A programmable logic device comprising the control unit (10) of one of claims 23 to 25, wherein the programmable logic device is adapted to control the process of changing the charging state of the control electrode (17) according to the method of one of claims 1 to 22.

## Patentansprüche

1. Verfahren zum Betreiben eines elektronischen Ventils (18), insbesondere eines Ventils, das für eine Verwendung in einem Leistungswandler ausgelegt ist, wobei
- ein Prozess zum Verändern eines Ladezustands einer Steuerelektrode (17), insbesondere einer Steuerelektrode eines isolierten Gates, des Ventils (18) wiederholt durchgeführt wird, wobei der Prozess ein Prozess ist, der entweder zum Anschalten oder zum Abschalten des Ventils durchgeführt werden soll,
- für eine Ausführung des Prozesses bestimmt wird, ob ein spezifischer Betriebszustand in einem vorgegebenen Zeitpunkt erreicht und ein entsprechendes Bestimmungsergebnis erreicht ist, wobei der spezifische Betriebszustand ein Zustand ist, in dem mindestens eine elektrische Größe eine vordefinierte Bedingung erfüllt und
**dadurch gekennzeichnet ist, dass**
der Prozess zum Verändern des Ladezustands ausgelegt ist für eine zukünftige Ausführung des Prozesses unter Verwendung des Bestimmungsergebnisses.

2. Verfahren nach dem vorhergehenden Anspruch, wobei
- abhängig von dem Bestimmungsergebnis mindestens eine Größe angepasst wird, um den Prozess zum Verändern des Ladezustands anzupassen, und
- dann, wenn der Betriebszustand nicht zu dem vorgegebenen Zeitpunkt erreicht wird, die mindestens eine Größe durch eine vorgegebene Menge oder durch einen vorgegebenen Bruchteil des augenblicklichen Werts der Größe und/oder durch einen vorgegebenen Bruchteil eines maximalen Werts der Größe angepasst wird.

3. Verfahren nach einem der vorhergehenden Ansprüche, wobei
- abhängig von dem Bestimmungsergebnis mindestens eine Größe angepasst wird, um den Prozess zum Verändern des Ladezustands anzupassen,
- dann, wenn der Betriebszustand nicht zu dem vorgegebenen Zeitpunkt erreicht wird, die mindestens eine Größe auf einen Wert geändert wird, der ausgewählt wird aus einem vorgegebenen Satz von Werten, und
- der Wert entsprechend dem Bestimmungsergebnis ausgewählt wird.

4. Verfahren nach einem der vorhergehenden Ansprüche, wobei ein neuer Wert der mindestens einen Größe berechnet wird, wobei der neue Wert für die nächst folgende Ausführung des Prozesses zum Verändern des Ladezustands der Steuerelektrode gültig ist, und wobei der neue Wert durch einen vorherigen Wert der Größe und durch das Bestimmungsergebnis eindeutig bestimmt ist.

5. Verfahren nach einem der drei vorhergehenden Ansprüche, wobei die mindestens eine Größe ein elektrischer Strom zu der Steuerelektrode (17) hin oder von der Steuerelektrode (17) weg ist.

6. Verfahren nach einem der vorhergehenden Ansprüche, wobei der Prozess zum Verändern des Ladezustands innerhalb von mehreren Zeitbereichen mit voreingestellten Längen durchgeführt werden soll.

7. Verfahren nach einem der vorhergehenden Ansprüche, wobei das Ventil (18) einen Kollektor, einen Emitter (Haupt) und einen Emitter (Kelvin) umfasst und wobei der spezifische Betriebszustand bestimmt wird, indem sowohl eine Spannung zwischen dem Kollektor und einem der Emitter als auch eine Spannung zwischen dem Emitter (Haupt) und dem Emitter (Kelvin) beobachtet wird.

8. Verfahren nach einem der vorhergehenden Ansprüche, wobei der Prozess zum Verändern des Ladezustands unter Verwendung des Bestimmungsergebnisses angepasst wird, so dass die Dauer des Veränderns des Ladezustands innerhalb eines Zeitfensters mit vorgegebener Länge gehalten wird.

9. Verfahren nach einem der vorhergehenden Ansprüche, wobei der vorgegebene Zeitpunkt durch ein Zeitintervall mit eingestellter Länge vorgegeben ist.

10. Verfahren nach Anspruch 9, wobei der Prozess bei Empfang eines Steuersignals bei einer Steuereinheit (10) eingeleitet wird, um den Prozess zum Verändern des Ladezustands der Steuerelektrode (17) zu steuern, und wobei das Zeitintervall zu dem Zeitpunkt des Empfangs des Steuersignals bei der Steuereinheit (10) beginnt.

11. Verfahren nach Anspruch 9, wobei der spezifische Betriebszustand ein erster spezifischer Betriebszustand ist und wobei das Zeitintervall zu einem Zeitpunkt beginnt, wenn das Ventil einen zweiten spezifischen Betriebszustand erreicht.

12. Verfahren nach einem der vorhergehenden Ansprüche, wobei der vorgegebene Zeitpunkt unter Verwendung eines Takts (11) definiert wird und wobei der Takt (11) auch als Taktsignalgenerator für eine logische Vorrichtung verwendet wird, die dafür ausgelegt ist, einen Arbeitsgang des Ventils zu steuern.

13. Verfahren nach einem der vorhergehenden Ansprüche, wobei der Prozess einer von mehreren aufeinanderfolgenden Prozessen ist, die durchzuführen sind, um den Ladungszustand der Steuerelektrode (17) zu ändern, insbesondere um das Ventil (18) an- oder abzuschalten

14. Verfahren nach einem der vorhergehenden Ansprüche, wobei ein Toleranzzeitintervall definiert wird, wobei der vorgegebene Zeitpunkt innerhalb des Toleranzzeitintervalls liegt und wobei bestimmt wird, dass der spezifische Betriebszustand zu dem vorgegebenen Zeitpunkt erreicht ist, wenn der spezifische Betriebszustand innerhalb des Toleranzzeitintervalls erreicht wird.

15. Verfahren nach einem der vorhergehenden Ansprüche, wobei die mindestens eine Größe, insbesondere ein elektrischer Strom zu der Steuerelektrode (17) hin oder von der Steuerelektrode (17) weg, angepasst werden kann, um den Prozess anzupassen und wobei mindestens eine Größe entsprechend dem Bestimmungsergebnis angepasst wird.

16. Verfahren nach Anspruch 15, wobei ein Anfangswert der mindestens einen Größe gewählt wird, die eine oder alle der folgenden Bedingungen erfüllt:
- eine Veränderungsrate einer elektrischen Spannung an dem Ventil (18) oder an einer Treiberschaltung (12) zum Steuern eines Arbeitsgangs des Ventils (18), insbesondere einer Gate-Emitter-Spannung,
- die elektrische Spannung,
- eine Veränderungsrate eines elektrischen Stroms, der durch das Ventil (18) fließt,
liegt/liegen innerhalb spezifizierter Grenzen und ist/sind insbesondere nicht größer als eine Grenze.

17. Verfahren nach Anspruch 15 oder 16, wobei, wenn der spezifische Betriebszustand nicht zu dem vorgegebenen Zeitpunkt erreicht wird, die mindestens eine Größe durch eine vorgegebene Menge oder durch einen vorgegebenen Bruchteil des augenblicklichen Werts der Größe angepasst wird.

18. Verfahren nach Anspruch 17, wobei die mindestens eine Größe durch einen Bruchteil, der in dem Bereich von 0,1 bis 1 % eines Maximalwertes der mindestens einen Größe liegt, angepasst wird, wenn der spezifische Betriebszustand nicht zu dem vorgegebenen Zeitpunkt erreicht wird.

19. Verfahren nach einem der Ansprüche 15 bis 18, wobei der Prozess zu dem vorgegebenen Zeitpunkt durch Verändern eines Wertes der mindestens einen Größe beendet wird, insbesondere durch Verändern des Stroms zu der Steuerelektrode (17) hin oder von der Steuerelektrode (17) weg.

20. Verfahren nach einem der vorhergehenden Ansprüche, wobei ein Ereignis definiert wird, bei dem dann, wenn das Ereignis eintritt und dadurch der spezifische Betriebszustand erreicht wird, ein zweiter Zeitpunkt bestimmt wird, wobei bewertet wird, ob der zweite Zeitpunkt früher oder später als der vorgegebene Zeitpunkt ist.

21. Verfahren nach Anspruch 20, wobei die Bewertung, ob der zweite Zeitpunkt früher oder später als der vorgegebene Zeitpunkt ist, für die Anpassung des Prozesses verwendet wird, falls notwendig, für die zukünftige Ausführung des Prozesses.

22. Verfahren nach einem der vorhergehenden Ansprüche, wobei eine Größe, die charakteristisch für einen Betriebszustand des Ventils (18) ist, zu dem vorgegebenen Zeitpunkt ausgewertet und mit einem Vergleichswert verglichen wird, um zu bestimmen, ob der spezifische Betriebszustand zu dem vorgegebenen Zeitpunkt erreicht ist.

23. Anordnung zum Betreiben eines elektronischen Ventils (18), insbesondere eines Ventils, das für eine Verwendung in einem Leistungswandler ausgelegt ist, wobei die Anordnung Folgendes umfasst:
- eine Treiberschaltung (12), die dafür ausgelegt ist, einen elektrischen Strom hin zu und/oder weg von einer Steuerelektrode (17), insbesondere von der Steuerelektrode eines isolierten Gates, des Ventils (18) zu steuern,
**gekennzeichnet durch**:
- eine Bestimmungsvorrichtung (16), die dafür ausgelegt ist, für eine Ausführung eines Prozesses zum Verändern eines Ladezustands der Steuerelektrode (17) zu bestimmen, ob ein spezifischer Betriebszustand des Ventils (18) zu einem vorgegebenen Zeitpunkt erreicht ist, und die dafür ausgelegt ist, ein entsprechendes Bestimmungsergebnis zu erreichen, wenn der Prozess ein Prozess ist, der entweder zum Anschalten oder zum Abschalten des Ventils durchgeführt werden soll, und wobei der spezifische Betriebszustand ein Zustand ist, in dem mindestens eine elektrische Größe eine vordefinierte Bedingung erfüllt, und
- eine Steuereinheit (10) für das wiederholte Steuern des Prozesses zum Verändern des Ladezustands, wobei die Steuereinheit (10) mit der Bestimmungsvorrichtung verbunden ist oder die Bestimmungsvorrichtung (16) enthält und wobei die Steuereinheit (10) dafür ausgelegt ist, eine zukünftige Ausführung des Prozesses zum Verändern des Ladezustands der Steuerelektrode (17) durchzuführen, indem die Treiberschaltung (12) unter Berücksichtigung des Bestimmungsergebnisses entsprechend gesteuert wird.

24. Anordnung nach Anspruch 23, wobei die Steuereinheit (10) mit einem Hochpräzisionstakt (11) verbunden ist, der Taktsignale zu der Steuereinheit (10) mit einer Genauigkeit von mindestens 100 ppm, vorzugsweise von mindestens 70 ppm übertragen kann.

25. Anordnung nach Anspruch 23 oder 24, wobei eine Ereignisbestimmungsvorrichtung (16) mit der Steuereinheit (10) verbunden ist und wobei die Ereignisbestimmungsvorrichtung (16) dafür ausgelegt ist, ein Auftreten eines vordefinierten Ereignisses während des Ladens oder Entladens der Steuerelektrode (17) zu bestimmen.

26. Wandler (21) zum Wandeln eines Stromes, insbesondere für eine Hochleistungsanwendung wie etwa eine elektrische Energieversorgung für einen Antriebsmotor (25) eines Schienentriebfahrzeugs, wobei der Wandler (21) eine Anordnung nach einem der Ansprüche 23 bis 25 umfasst, wobei der Wandler (21) durch wiederholtes An-und Ausschalten des Ventils (18) betrieben werden kann und wobei die Anordnung und die Steuerelektrode (17) über eine Verbindung zum Entladen und oder Laden der Steuerelektrode miteinander verbunden sind.

27. Programmierbare Logikvorrichtung, die die Steuereinheit (10) nach einem der Ansprüche 23 bis 25 umfasst, wobei die programmierbare Logikvorrichtung dafür ausgelegt ist, den Prozess zum Verändern des Ladezustands der Steuerelektrode (17) gemäß dem Verfahren nach einem der Ansprüche 1 bis 22 zu steuern.

## Revendications

1. Procédé d'actionnement d'une valve électronique (18), en particulier une valve adaptée pour une utilisation dans un convertisseur de puissance, dans lequel
- un processus de changement d'un état de charge d'une électrode de commande (17), en particulier d'une grille isolée, de la valve (18) est effectué de façon répétée, dans lequel le processus est un processus à réaliser soit pour activer, soit pour désactiver la valve,
- pour une exécution du processus, il est déterminé si un état d'actionnement spécifique est atteint à un moment prédéterminé et un résultat de détermination correspondant est obtenu, dans lequel l'état d'actionnement spécifique est un état dans lequel au moins une quantité électrique remplit une condition prédéfinie et
**caractérisé en ce que**
- le processus de changement de l'état de charge est adapté pour une exécution future du processus à l'aide du résultat de détermination.

2. Procédé selon la revendication précédente, dans lequel
- en fonction du résultat de détermination, au moins une quantité est ajustée afin d'adapter le processus de changement de l'état de charge, et
- si l'état d'actionnement n'est pas atteint au moment prédéterminé, la au moins une quantité est ajustée d'une quantité prédéterminée ou d'une fraction prédéterminée de la valeur instantanée de la quantité et/ou d'une fraction prédéterminée d'une valeur maximale de la quantité.

3. Procédé selon l'une des revendications précédentes, dans lequel :
- en fonction du résultat de détermination, au moins une quantité est ajustée afin d'adapter le processus de changement de l'état de charge,
- si l'état d'actionnement n'est pas atteint au moment prédéterminé, la au moins une quantité est changée en une valeur choisie dans un ensemble prédéterminé de valeurs, et
- la valeur est choisie selon le résultat de détermination.

4. Procédé selon l'une des revendications précédentes, dans lequel une nouvelle valeur de la au moins une quantité est calculée, laquelle nouvelle valeur est valable pour l'exécution suivante du processus de changement de l'état de charge de l'électrode de commande, et dans lequel la nouvelle valeur est déterminée sans ambigüité par une valeur précédente de la quantité et par le résultat de détermination.

5. Procédé selon l'une des trois revendications précédentes, dans lequel la au moins une quantité est un courant électrique à destination ou en provenance de l'électrode de commande (17).

6. Procédé selon l'une des revendications précédentes, dans lequel le processus de changement de l'état de charge est à effectuer à l'intérieur d'une pluralité de fuseaux horaires de longueurs établies.

7. Procédé selon l'une des revendications précédentes, dans lequel la valve (18) comprend un collecteur, un émetteur (principal) et un émetteur (Kelvin) et dans lequel l'état d'actionnement spécifique est déterminé en observant une tension entre le collecteur et l'un des émetteurs ainsi qu'en observant une tension entre l'émetteur (principal) et l'émetteur (Kelvin).

8. Procédé selon l'une des revendications précédentes, dans lequel le processus de changement de l'état de charge est adapté à l'aide du résultat de détermination de sorte que la durée de changement de l'état de charge est maintenue à l'intérieur d'une fenêtre de temps de longueur prédéterminée.

9. Procédé selon l'une des revendications précédentes, dans lequel le moment prédéterminé est prédéterminé par un intervalle de temps de longueur établie.

10. Procédé selon la revendication 9, dans lequel le processus est initié à la réception d'un signal de commande au niveau d'une unité de commande (10) pour commander le processus de changement de l'état de charge de l'électrode de commande (17) et dans lequel l'intervalle de temps démarre au moment de la réception du signal de commande au niveau de l'unité de commande (18).

11. Procédé selon la revendication 9, dans lequel l'état d'actionnement spécifique est un premier état d'actionnement spécifique et dans lequel l'intervalle de temps démarre à un moment où la valve atteint un second état d'actionnement spécifique.

12. Procédé selon l'une des revendications précédentes, dans lequel le moment prédéterminé est défini à l'aide d'une horloge (11) et dans lequel l'horloge (11) est utilisée ainsi qu'un générateur de signal d'horloge pour un dispositif logique, qui est adapté pour commander un actionnement de la valve.

13. Procédé selon l'une des revendications précédentes, dans lequel le processus est l'un d'une pluralité de processus consécutifs à effectuer afin de changer l'état de charge de l'électrode de commande (17), en particulier afin d'activer ou afin de désactiver la valve (18).

14. Procédé selon l'une des revendications précédentes, dans lequel un intervalle de temps de tolérance est défini, dans lequel le moment prédéterminé se situe à l'intérieur de l'intervalle de temps de tolérance et dans lequel il est déterminé que l'état d'actionnement spécifique est atteint au moment prédéterminé, si l'état d'actionnement spécifique est atteint à l'intérieur de l'intervalle de temps de tolérance.

15. Procédé selon l'une des revendications précédentes, dans lequel au moins une quantité, en particulier un courant électrique à destination ou en provenance de l'électrode de commande (17), peut être ajustée afin d'adapter le processus et dans lequel la au moins une quantité est ajustée proportionnellement au résultat de détermination.

16. Procédé selon la revendication 15, dans lequel une valeur initiale de la au moins une quantité est choisie, laquelle remplit l'une ou la totalité des conditions suivantes :
- une vitesse de changement d'une tension électrique au niveau de la valve (18), ou au niveau d'un circuit d'attaque (12) pour commander un actionnement de la valve (18), en particulier une tension grille-émetteur,
- la tension électrique,
- une vitesse de changement d'un courant électrique circulant à travers la valve (18)
est/sont à l'intérieur de limites spécifiées, en particulier non supérieures à une limite.

17. Procédé selon la revendication 15 ou 16, dans lequel, si l'état d'actionnement spécifique n'est pas atteint au moment prédéterminé, la au moins une quantité est ajustée d'une quantité prédéterminée ou d'une fraction prédéterminée de la valeur instantanée de la quantité.

18. Procédé selon la revendication 17, dans lequel la au moins une quantité est ajustée d'une fraction qui se situe dans la plage de 0,1 à 1 % d'une valeur maximale de la au moins une quantité, si l'état d'actionnement spécifique n'est pas atteint au moment prédéterminé.

19. Procédé selon l'une des revendications 15 à 18, dans lequel le processus est terminé au moment prédéterminé en changeant une valeur de la au moins une quantité, en particulier en changeant le courant à destination ou en provenance de l'électrode de commande (17).

20. Procédé selon l'une des revendications précédentes, dans lequel un événement est défini, dans lequel un second moment, lorsque l'événement se produit et qu'ainsi l'état d'actionnement spécifique est atteint, est déterminé et dans lequel il est évalué si le second moment est antérieur ou postérieur au moment prédéterminé.

21. Procédé selon la revendication 20, dans lequel l'évaluation consistant à savoir si le second moment est antérieur ou postérieur au moment prédéterminé est utilisée pour l'adaptation du processus, si nécessaire, pour l'exécution future du processus.

22. Procédé selon l'une des revendications précédentes, dans lequel une quantité, qui est caractéristique pour un état d'actionnement de la valve (18), est évaluée au moment prédéterminé dans le temps et est comparée à une valeur de comparaison afin de déterminer si l'état d'actionnement spécifique est atteint au moment prédéterminé.

23. Agencement pour actionner une valve électronique (18), en particulier une valve adaptée pour une utilisation dans un convertisseur de puissance, dans lequel l'agencement comprend :
- un dispositif d'attaque (12) adapté pour piloter un courant électrique à destination et/ou en provenance d'une électrode de commande (17), en particulier d'une grille isolée, de la valve (18),
**caractérisé par**
- un dispositif de détermination (16) adapté pour déterminer pour une exécution d'un processus de changement d'un état de charge de l'électrode de commande (17) si un état d'actionnement spécifique de la valve (18) est atteint à un moment prédéterminé et adapté pour obtenir un résultat de détermination correspondant, dans lequel le processus est un processus à réaliser soit pour activer, soit pour désactiver la valve, et dans lequel l'état d'actionnement spécifique est un état dans lequel au moins une quantité électrique remplit une condition prédéfinie, et
- une unité de commande (10) pour commander de façon répétée le processus de changement de l'état de charge, dans lequel l'unité de commande (10) est connectée au dispositif de détermination ou comprend le dispositif de détermination (16) et dans lequel l'unité de commande (10) est adaptée pour effectuer une exécution future du processus de changement de l'état de charge de l'électrode de commande (17) en commandant le dispositif d'attaque (12) de manière correspondante, en prenant en considération le résultat de détermination.

24. Agencement selon la revendication 23, dans lequel l'unité de commande (10) est connectée à une horloge de haute précision (11) qui est capable de transférer des signaux d'horloge à l'unité de commande (10) à une précision d'au moins 100 ppm, de préférence d'au moins 70 ppm.

25. Agencement selon la revendication 23 ou 24, dans lequel un dispositif de détermination d'événement (16) est connecté à l'unité de commande (10) et dans lequel le dispositif de détermination d'événement (16) est adapté pour déterminer une occurrence d'un événement prédéfini durant la charge ou la décharge de l'électrode de commande (17).

26. Convertisseur (21) pour convertir un courant, en particulier pour une application de grande puissance telle que la fourniture d'énergie électrique à un moteur d'entraînement (25) d'un véhicule de traction de chemin de fer, dans lequel le convertisseur (21) comprend l'agencement de l'une des revendications 23 à 25, dans lequel le convertisseur (21) peut être actionné en activant et en désactivant de façon répétée la valve (18) et dans lequel l'agencement et l'électrode de commande (17) sont connectées l'une à l'autre par l'intermédiaire d'une connexion pour décharger et/ou charger l'électrode de commande.

27. Dispositif logique programmable comprenant l'unité de commande (10) de l'une des revendications 23 à 25, dans lequel le dispositif logique programmable est adapté pour commander le processus de changement de l'état de charge de l'électrode de commande (17) selon le procédé de l'une des revendications 1 à 22.
